# NEW EUROPEAN PATENT SPECIFICATION

(11) **EP 0 207 244 B2**
(45) Date of publication and mention of the opposition decision: **31.03.1999**
(45) Mention of the grant of the patent: 11.11.1992
(21) Application number: 86105554.9
(22) Date of filing: 22.04.1986
(51) Int. Cl.: C25D 1/04

(54) **Process for the production of an electroposited copper foil.**
Verfahren zur Herstellung einer Kupferfolie durch elektrolytische Abscheidung.
Procédé pour la préparation d'und Feuille de cuivre par électrodéposition.

(30) Priority: 05.07.1985 JP 146623/85
(43) Date of publication of application: 07.01.1987
(73) Proprietor: MITSUI MINING & SMELTING CO., LTD., Chuo-ku Tokyo (JP)
(72) Inventor: Ueno, Kuniki, Kitaadachi-gun Saitama-ken (JP); Nabekura, Kazuyoshi, Ageo-shi Saitama-ken (JP); Hirasawa, Yutaka c/o Mitsui Mining & Smelting Co., Nihombashi-Muromachi Chuo-ku (JP); Fujiki, Makoto, Kitaadachi-gun Saitama-ken (JP)
(74) Representative: WILHELMS, KILIAN & PARTNER Patentanwälte

(56) References cited:
- WO-A-85/02870
- CH-A- 494 824
- American Electroplaters' Society, 32nd annual Convention, p. 173-192 (1944)
- the practical plating for on-the-spot technicians, pibl. Yoshody (1983)
- Product finishing, Lugg et al., p. 38-40 (1983)
- Handbook of Metal Finishing Techniques p. 278-281 (1972), 7th edition

## Description

The invention relates to a continuous process for producing an electrodeposited copper foil.

Recently, in the field of electronic industry including computers, multistratification of circuits has intensively been attempted to attain high density and reliability. Paticularly, multilayer printed circuit boards are prevailing.

Heretofore, electrodeposited copper foils have generally been used in copper-clad laminates. Such foils are obtained by an electrolytic method which comprises rotating a cathode drum in a glue- or the like added electrolyte passing through an electrolytic cell to electrodeposit copper on the rotating cathode drum, and then continuously peeling the thus electrodeposited copper foil therefrom while rotating the drum.

The electrodeposited copper foils produced by the prior art method are not greatly improved in mechanical properties by annealing at a temperature of as low as about 170°C, and the foils are less endurable to folding than wrought copper foils.

The prior art electrodeposited copper foils have an elongation of only about 3.0% or less at elevated temperature (for example, in an atmosphere at 180° C), and they are classified into Classes 1 to 4 depending on their performances in accordance with IPC-CF-150E whicn is ANSI Standard on copper foils. Particularly, Class 4 is required to have an elongation of at least 4% at 180°C by annealing. It has been considered difficult for the copper foils to have an elongation of at least 4% at 180 °C without annealing.

In addition, prior art electrodeposited copper foils are probable to crack in the step of preparing printed circuit boards, particularly multilayer printed circuit boards, due to the application of heat stress to the foils in this step, and they are not so reliable as to be used in the preparation of flexible print circuit boards for which the folding endurance is important.

It is the object of the present invention to provide a process for continuously producing an electrodeposited copper foil which exhibits a high elongation and a high tensile strength not only at room temperature but also at an elevated temperature of for example 180°C.

The present inventors had made tests several ten times in attempts to produce electrodeposited copper foils which are not cracked under the application of heat stress thereto or can have a high elongation at elevated temperature (180°C, for example) in accordance with the requirements prescribed by MIL-P-5510C.

During the practice of said tests, they found, when trey treated an electrolyte for the purpose of purifying the electrolyte, that if a copper ion-containing electrolyte at least 60 vol.% of which had continuously been treated with activated carbon was immediately supplied to electrolysis then electrodeposited copper foils having very peculiar mechanical properties were obtained. This invention is based on this finding or discovery.

More specifically, the present invention resides in a continuous process for producing an electrodeposited copper foil which comprises electrolyzing a copper ion-containing electrolyte which consists of 50-100 g/l of copper ion and a member selected from the group consisting of 80-180 gl of sulfuric acid, 5-50 gl of hydrochloric acid, and a borofluoride in an amount corresponding to a pH value of 0.1-2.0 the electrolyzing being carried out at an electrolyte temperature of 40-60°C and a current density of 30-120A/dm² whereby at least 60 vol.% of said electrolyte has been continuously treated with activated carbon by passing through an activated carbon column at a velocity of 5-100 cm.s. said electrolyte being continuously subjected to said electrolyzing step within 20 minutes after said treatment with activated carbon.

The operating conditions to produce an electrodeposited copper foil are in particular as follows:
1. Copper concentration in a bath 50-100 g/l, preferably 70-90 g/l
   In a case where the copper concentration is less than 50 gl, it is impossible to electrolyse at a high current density. On the other hand, the copper salt used is apt to be crystallized from the bath at a copper concentration more than 100 g/l.
2. Acid concentration in the bath
   (1) When sulfuric acid is used,
      80-180 g/l, preferably 100-150 g/l
   (2) When hydrochloric acid is used,
      5-50 g/l, preferably 10-30 g/l
   (3) When a pyrophosphate is used,
      200-500 g/l, preferably 240-270 g/l (for potassium salt),
   (4) When a borofluoride is used,
      the pH value of the bath is in the range of 0.1-2,0, preferably 0.3-1,4

   If the acid concentration of the bath is lower than the above-mentioned lower limit then the bath voltage will uneconomically be high, whereas if it is higher than the upper limit then the electrode will undesirably be consumed rapidly.
3. Bath temperature
   40-60° C, preferably 45-55 ° C
   At a bath temperature of lower than 40°C, a copper salt tends to be crystallized from the bath in which the salt is dissolved. On the other hand, unusual copper deposition is apt to be caused at a temperature higher than 60°C.
4. Velocity
   5-100 cm/s, preferably 20-50 cm/s
   It is necessary to treat 60-100% of an electrolyte with activated carbon, or else no electrodeposited copper foils having satisfactory properties according to this invention are obtained. The use of a velocity of 5 cm/s will allow almost 100% of an electrolyte to be treated with activated carbon, whereas the use of a velocity higher than 100 cm.s will result in disadvantageously requiring a large-sized tower packed with activated carbon.
5. Current densiiy
   30-120 A/dm², preferably 50-100 A/dm²

The use of a current density lower than 30 A/dm² will result in the production of foils having unsatisfactory properties, whereas the use of over 120 A/dm² will tend to cause unusual copper deposition.

To obtain electrodeposited copper foils according to the present invention it is required to use a copper ion-containing electrolyte at least 60 vol.% of which has been treated with activated carbon. In a case where less than 60 vol.% of the electrolyte has been so treated, electrodeposited copper foils having a high elongation at elevated temperature will not be obtained. In addition, it is necessary to use the electrolyte having been treated activated carbon, within 20 minutes after said treatment. If this electrolyte is used more than 20 minutes later than said treatment then electrodeposited copper foils having high elongation at elevated temperature will not be obtained. For reference, such treatment with activated carbon has heretofore been carried out for the purpose of purification of electrolytes: unlike the present invention, however, the electrolytes so treated are not intended to be subjected to electrolysis within 20 minutes after said treatment, but are usually stored for at least one day.

The process for the producing an electrodeposited copper foil of this invention will be explained below by reference to the accompanying drawings in which:
Fig. 1 is a schematic view of an example of an apparatus for the continuous production of electrodeposited copper foils;
Figs. 2(a) and 2(b) are microscopic photographs (1000 magnifications) showing the metallograph of an electrodeposited copper foil produced by the process according to the present invention before and after annealing, respectively;
Figs. 3(a) and 3(b) are microscopic photographs (1000 magnifications) showing the metallograph of a comparative electrodeposited copper foil before and after annealing, respectively; and
Figs. 4(a) and 4(b) are microscopic photographs (1000 magnifications) showing the metallograph of another comparative wrought copper foil before and after annealing, respectively.

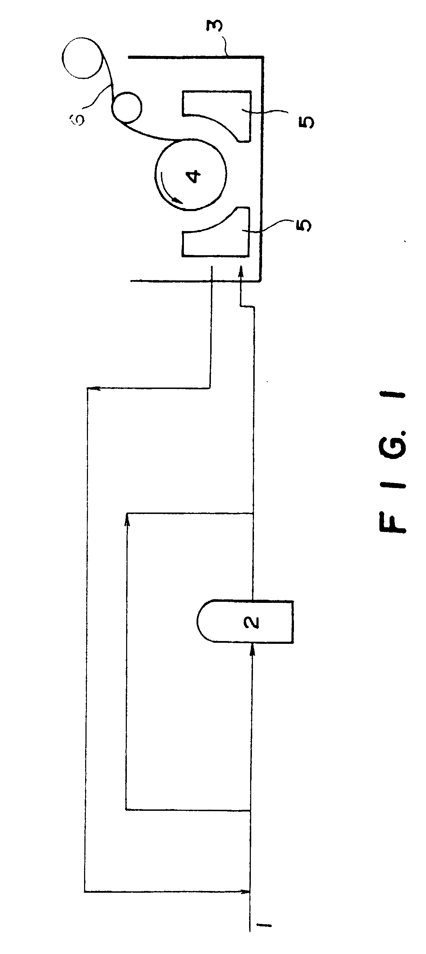

Referring now to Fig. 1, numerals 1 to 6 indicate a line for introducing an electrolyte, a tower packed with activated carbon, an electrolytic cell, a cathode drum, insoluble anodes and an electrodeposited copper foil, respectively. The symbol "arrow" indicates the direction in which electrolyte flows.

The process for producing electrodeposited copper foils of this invention is almost the same as the prior art process in that these processes comprise continuous electrode-position, put the former is clearly characterized by passing at least a specific proportion of an electrolyte through an activated carbon-packed layer, for example at a velocity of 30 cm/s or less, immediately before electrolysis and then subjecting both the activated carbon-treated portion and the remainder of the electrolyte to electrolysis within 20 minutes of said treatment with activated carbon, the electrolyzing being carried out at an electrolyte temperature of 40-60°C an a current density of 30-120 A/dm².

More particularly, a fixed amount of an electrolyte introduced through a line 1 for supplying an electrolyte is passed into an activated carbon-packed tower 2 where the specific amount of the electrolyte is treated with the activated carbon. The specific portion of the electrolyte is then passed, together with the rest of the electrolyte, into an electrolytic cell where the whole of the electrolyte is electrolyzed within 20 minutes after said treatment with activated carbon. It is necessary in this electrolysis that at least 60 vol.% of the electrolyte in the electrolytic cell 3 have previously been treated and the activated carbon-treated portion of the electrolyte, together with the rest thereof, be subjected to electrolysis within 20 minutes after said treatment with activated carbon. The electrolysis is carried out using the cathode drum 4 and the insoluble anodes 5 to deposit copper foil 6 on the cathode drum 4. The composition of the electrolyte, the time for the electrolysis, the current density, the temperature of the electrolytic bath, and the like are suitably determined as desired. The electrodeposited copper foil 6 on the cathode drum 4 is peeled off and then used for copper-clad laminates and the like.

The electrodeposited copper foils thus formed are different from the prior art one because of both the effect of purification of an electrolyte with activated carbon and the effect which is considered to be attributed to the oxidation-reduction of metal cation in the electrolyte, and they are satisfactory in every mechanical property as compared with conventional electrodeposited copper foils and exhibit the same or excellent properties even as compared with wrought copper foils. Further, they are greatly increased particularly in elongation at elevated temperature and are extremely satisfactory in folding endurance after heating (hereinafter sometimes referred to "post-heating folding endurance") as compared with the conventional electrodeposited copper foils.

This invention will be better understood by the following Examples and Comparative Examples.

### Example 1

Using, as the electrolyte, an acidic copper sulfate solution comprising 280 g/l of copper sulfate (CuSO₄·5H₂O) and 100 g/l of sulfuric acid, electrolysis was effected at a solution temperature of 45 °C and a current density of 50 A/dm² and also under the following conditions.

The electrolysis was continuously carried out using electrolyte 90 vol.% of which was continuously treated with activated carbon at a velocity of 20 cm/s. The portion of the electrolyte thus treated was subjected, together with the rest thereof, to electrolysis 10 minutes after said treatment.

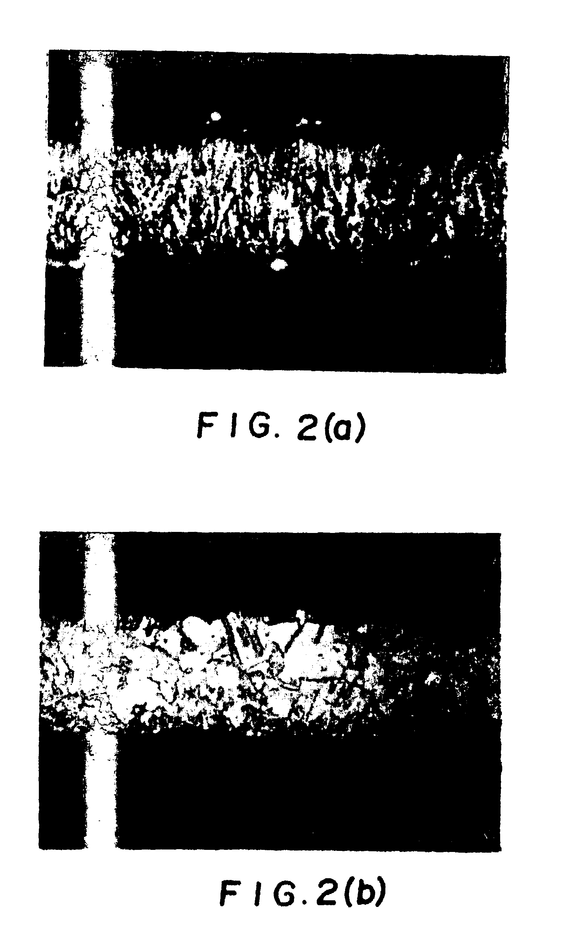

The thus obtained 35 µm-thick electrodeposited copper foils exhibited tensile strength, elongation and MIT folding endurance at room temperature (23°C), after heating at 180°C for one hour and at elevated temperature (180°C), respectively, as shown in Table 1. At the same time, the standards in Classes 1-4 prescribed in IPC-CF-150E are also shown in Table 1. Further, the microscopic photographs (1000 magnifications) of metallographs of said electrodeposited copper foil s as received and after heating, are indicated in Figs. 2(a) and (b), respectively.

### Example 2

The procedure of Example 1 was followed except that an acidic copper sulfate solution comprising 320 g/l of copper sulfate (CuSO₄·5H₂O) and 130 g/l of sulfuric acid was used as the electrolyte, and the electrolysis thereof was carried out at a solution temperature of 50 °C, a current density of 80 A/dm² while continuously treating 80% of the electrolyte with activated carbon at a velocity of 35 cm/sec and subjecting the thus treated portion of the electrolyte, together with the rest thereof, to electrolysis 5 minutes after said treatment with activated carbon.

### Example 3

The procedure of Example 1 was followed except that an acidic copper sulfate solution comprising 380 g/l of copper sulfate (CuSO₄·5H₂O) and 150 g/l of sulfuric acid was used as the electrolyte, and the electrolysis thereof was carried out at a solution temperature of 55 °C, a current density of 100 A/dm² while continuously treating 70% of the electrolyte with activated carbon at a velocity of 50 cm/sec and subjecting the thus treated portion of the electrolyte, together with the rest thereof, to electrolysis three minutes after said treatment with activated carbon.

### Example 4

Following the procedure of Example 1, but using as the electrolyte an acidic copper chloride solution comprising 110 g/l of cupric chloride (CuCl₂) and 20 g/l of hydrochloric acid and carrying out the electrolysis of the chloride solution at a solution temperature of 55° C, a current density of 80 A/dm² while continuously treating 70% of the electrolyte with activated carbon at a velocity of 50 cm/sec and subjecting the thus treated portion of the electrolyte, together with the rest thereof, to electrolysis 10 minutes after said treatment with activated carbon.

### Example 5

Following the procedure of Example 1, but using as the electrolyte an acidic copper chloride solution comprising 140 g/l of cupric chloride (CuCl₂) and 10 g/l of hydrochloric acid and carrying out the electrolysis of the chloride solution at a solution temperature of 45 °C, a current density of 50 A/dm² while continuously treating 90% of the electrolyte with activated carbon at a velocity of 20 cm/sec and subjecting the thus treated portion of the electrolyte, together with the rest thereof, to electrolysis 5 minutes after said treatment with activated carbon.

### Comparative Example 1

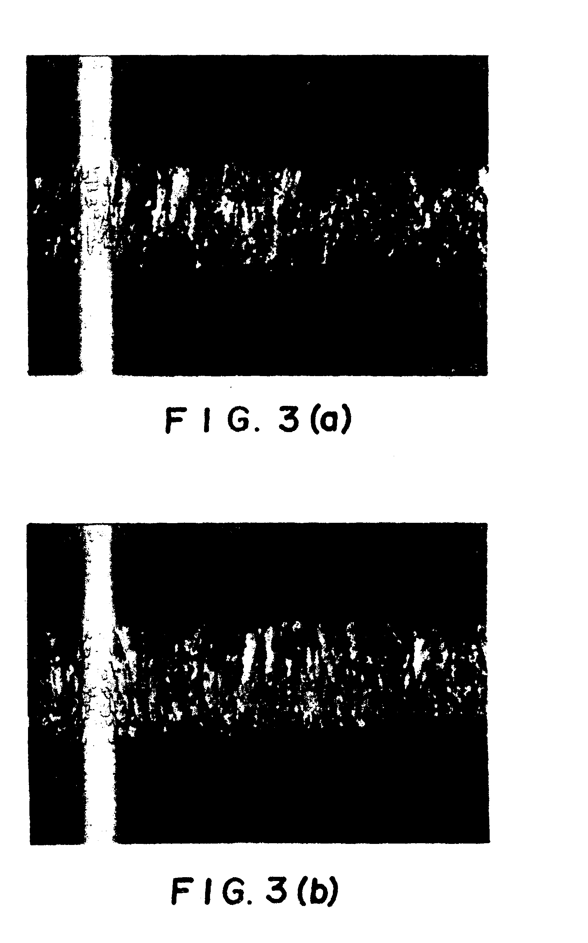

The procedure of Example 1 was followed except that no treatment with activated carbon was done, to obtain comparative 35 µm-thick electrodeposited copper foils which exhibited tensile strength, elongation and MIT folding endurance at room temperature (23° C), after heating at 180° C for one hour and at elevated temperature (180° C), respectively, as shown in Table 1. In addition, the microscopic photographs (1000 magnifications) of metallographs of said copper foils as received and after heating, are indicated in Figs. 3(a) and 3(b), respectively.

### Comparative Example 2

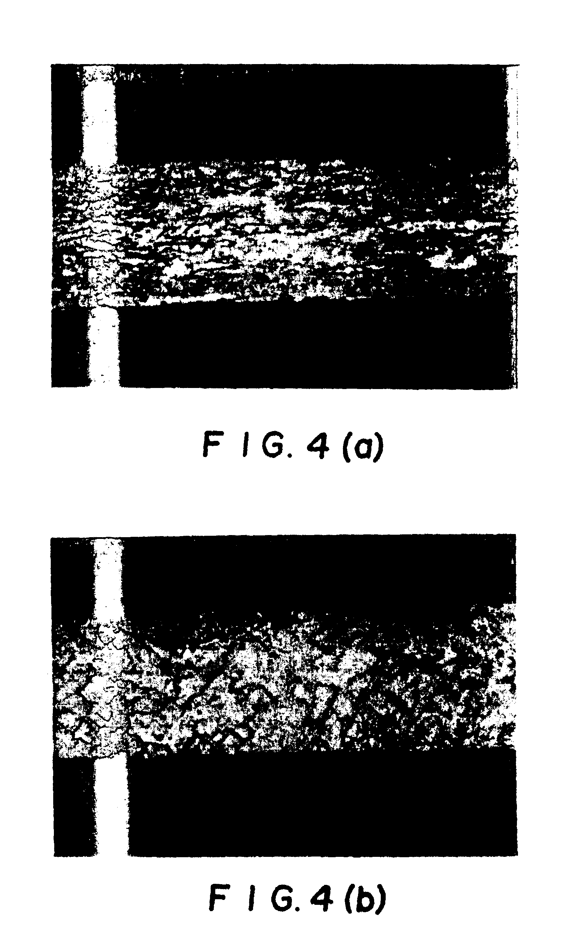

35 µm-thick wrought copper foils (wrought copper foils TPC-35 for use in printed circuits, produced by Mitsui Mining & Smelting Co., Ltd.) exhibited tensile strength, elongation and MIT folding endurance at room temperature, after heating at 180° C for one hour and at elevated temperature (180° C), respectively, as shown in Table 1. Further, the microscopic photographs (1000 magnifications) of metallographs of said wrought copper foils as received and after heating, are indicated in Figs. 4(a) and 4(b), respectively.

**Table 1**

| Examples and Comparative Examples | | Tensile strength (Kg/mm²) | Elongation (%) | MIT Folding endurance (cycles) |
|---|---|---|---|---|
| Example 1 | Room temp. | 39.5 | 15.0 | 31 |
| | Post-heating | 23.0 | 19.0 | 48 |
| | Elev. temp. | 15.4 | 33.6 | - |
| | | | | |
| Example 2 | Rcom temp. | 35.0 | 15.5 | 37 |
| | Post-heating | 25.8 | 19.7 | 42 |
| | Elev. temp. | 15.3 | 32.3 | - |
| | | | | |
| Example 3 | Room temp. | 40.6 | 14.6 | 35 |
| | Post-heating | 23.8 | 19.4 | 47 |
| | Elev. temp. | 15.3 | 34.4 | - |
| | | | | |
| Example 4 | Room temp. | 30.9 | 17.8 | 32 |
| | Post-heating | 26.1 | 21.1 | 41 |
| | Elev. temp. | 15.8 | 35.2 | - |
| | | | | |
| Example 5 | Room temp. | 36.9 | 13.7 | 33 |
| | Post-heating | 25.8 | 22.9 | 43 |
| | Elev. temp. | 15.8 | 34.2 | - |
| Comparative | Elev. temp. | 15.8 | 34.2 | - |
| Example 1 | Room temp. | 37.2 | 8.5 | 18 |
| | Post-heating | 36.5 | 11.5 | 22 |
| | Elev. temp. | 18.7 | 1.4 | - |
| Comparative | | | | |
| Example 2 | Room temp. | 45.5 | 1.3 | 10 |
| | Post-heating | 19.4 | 11.3 | 55 |
| | Elev. temp. | 14.1 | 12.0 | - |
| IPC Standard | | | | |
| Class 1 | Room temp. | at least 21.09 | at least 3.0 | - |
| | Elev. temp. | Not applicable | - | - |
| | | | | |
| Class 2 | Room temp. | at least 21.09 | at least 10.0 | - |
| | Elev. temp. | Not applicable | - | - |
| | | | | |
| Class 3 | Room temp. | at least 21.09 | at least 3.0 | - |
| | Elev. temp. | at least 14.06 | at least 2.0 | - |
| | | | | |
| Class 4 | Room temp. | at least 14.06 | at least 10.0 | - |
| | Elev. temp. | at least 10.55 | at least 4.0 | |
| Note: Room temp.: At room temperature (23°C). Post-heating: After heating to 180°C for one hour. Elev. temp.: At elevated temperature (180°C). | | | | |

As is seen from Table 1, the electrodeposited copper foils of this invention meets all the requirements in Classes 1 to 4 prescribed in IPC-CF-150E and exhibits their folding endurance which is in the preferable range. In contrast, the comparative el odeposited copper foils of Comparative Example 1 do not satisfy the elongation (room temp.) of Class 2 and the elongations (elev. temp.) of Classes 3 and 4; they are required to be heat treated, and also exhibit low folding endurance as compared with those obtained in Example 1. The wrought copper foils obtained in Comparative Example 2 do not satisfy the elongation (room temp.) of Classes 1 to 4, are required to be heat treated, and exhibit low folding endurance as compared with those obtained in Example 1.

The metallographs of copper foils (as received and after heating) of Example 1 and Comparative Examples 1-2 are shown in Figs. 2(a), 2(b), 3(a), 3(b), 4(a) and 4(b), respectively, from which it is evident that the electrodeposited copper foils of Example 1, after heated at 180 ° C for one hour, form macrocrystals, being different from the electrodeposited copper foils of Comparative Example 1 (refer to Fig. 2(b)), but similar to the wrought copper foils of Comparative Example 2. As is indicated in Table 1, the copper foils of Example 1 exhibit an elongation (post-heating) of as high as 19% and are much improved in folding endurance which is required in flexible printed circuit boards.

The above results (Table 1) were obtained by testing the 35 µm-thick copper foils, and approximately the same results were also obtained by the same test of 18 µm-thick and 70µm-thick copper foils.

### Examples 6-8 and Comparative Examples 3-4

Using, as the electrolyte, an acidic copper sulfate solution comprising 280 g/l of copper sulfate (CuSO₄^{•}5H₂O) and 100 g/l of sulfuric acid, was subjected to electrolysis at a solution temperature of about 50° C and a current density of 50-150 A/dm² and under the following further conditions.

The electrolysis was continuously carried out while using the electrolyte which had continuously been partly or wholly treated with activated carbon at a velocity of 30 cm/sec. The partial or whole electrolyte so treated with activated carbon was used in the electrolysis 5 minutes after said treatment, thereby obtaining 35 µm-thick electrodeposited copper foils.

Table 2 indicates the elongations (at elevated temperature, 180°C) of the thus obtained elecodeposited copper foils and the portion of the electrolyte treated with activated carbon.

**Table 2**

| Examples and Comp. Examples | The portion of electrolyte treated with activated carbon (vol.%) | Elongation (elev. temp.) (%) |
|---|---|---|
| Comp. Example 3 | 0 | 2.0 |
| Comp. Example 4 | 40 | 3.5 |
| Example 6 | 60 | 12.5 |
| Example 7 | 80 | 27.0 |
| Example 8 | 100 | 35.0 |

It is apparent from Table 2 that the electrodeposited copper foils of Examples 6 to 8 obtained by using in the electrolysis the electrolyte at least 60 vol.% of which was treated with activated carbon before the electrolysis exhibit high elongations (elev. temp.) respectively, whereas those of Comparative Examples 3 to 4 obtained without such treatment with activated carbon exhibit low elongations (elev. temp.) respectively. From this it is found necessary in this invention to use an electrolyte at least 60 vol.% of which is treated with activated carbon before electrolysis and to subject the whole of the electrolyte to electrolysis within 20 minutes after said treatment.

### Examples 9-11 and Comparative Example 5

An acidic copper sulfate solution comprising 280 g/l of copper sulfate (CuSO₄·5H₂O) and 100 g/l of sulfuric acid was used as the electrolyte.

The electrolyte was continuously electrolyzed at a solution temperature of about 50°C, a current density of 50 A/dm² while at least 80 vol.% of the electrolyte was continuously treated with activated carbon at a velocity of 30 cm/s. thereby obtaining 35 µm-thick electrodeposited copper foils.

In these Examples and Comparative Example, the portions of the electrolyte treated with activated carbon were subjected to electrolysis 2.5, 10, 20 and 30 minutes after said treatment, respectively.

The elongations (elev. temp.) of thus obtained 35 µm-thick copper foils and the time between the treatment with activated carbon and the electrolysis, are shown in Table 3.

**Table 3**

| Examples and Comp. Example | Time between activated carbon treatment and electrolysis (min.) | Elongation (elev. temp.) (%) |
|---|---|---|
| Example 9 | 2.5 | 29.0 |
| Example 10 | 10 | 14.5 |
| Example 11 | 20 | 8.5 |
| Comp. Example 5 | 30 | 3.0 |

As is indicated in Table 3, the electrodeposited copper foils of Examples 9-11, obtained by electrolyzing the electrolyte the specific portion of which was treated with activated carbon within 20 minutes before electrolysis, exhibit high elongations (elev. temp.); on the other hand, the electrolytic copper foil of Comparative Example 5, obtained by electrolyzing the electrolyte the specific portion of which was treated with activated carbon 30 minutes before electrolysis, exhibit low elongation (elev. temp.). This substantiates that it is necessary in this invention to electrolyze an electrolyte the specific portion (at least 60 vol.%) of which is treated with activated carbon within 20 minutes before the electrolysis.

The electrodeposited copper foils obtained according to this invention exhibit high tensile strength and elongation at room temperature and elevated temperature and, therefore, they may be used for multilayer printed circuit boards without generating cracks in the heated process and they are satisfactory in folding endurance. Thus, they may highly reliably be used even in the preparation of flexible printed circuit boards.

## Claims

1. A continuous process for producing an electrodeposited copper foil which comprises :
electrolyzing a copper ion-containing electrolyte of sulfuric of 50-100 g/l of copper ion and a member selected from the group consisting of 80-180 g/l of sulfuric acid. 5-50 g/l of hydrochloric acid., and a borofluoride in an amount corresponding to a pH value of 0.1-2.0, the electrolyzing being carried out at an electrolyte temperature of 40-60°C, and a current density of 30-120 A/dm² whereby at least 60 vol.% of said electrolyte has been continuously treated with activated carbon by passing through an activated carbon. column at a velocity of 5.100 cm/s said electrolyte being continuously subjected to said electrolyzing step within 20 minutes after said treatment with activated carbon.

2. A process according to claim 1, wherein the copper ion is derived from cupric sulfate or cupric chloride.

## Patentansprüche

1. Kontinuierliches Verfahren zum Herstellung einer elektrolytisch abgeschiedenen Kupferfolie, umfassend:
Elektrolysieren eines Kupferionen enthaltenden Elektrolyten, der aus 50-100 g/l Salzsäure und 80-180 g/l Schwefelsäure, oder 5-50 g/l Salzsäure und einem Borfluorid in einer Menge, die einem pH-Wert von 0,1-2,0 entspricht, besteht, wobei das Elektrolysieren bei einer Elektrolyttemperatur von 40-60°C und einer Stromdichte von 30-120 A/dm² durchgeführt wird, und wobei mindestens 60 Vol.% des Elektrolyten kontinuierlich mit Aktivkchle dadurch behandelt wurden, in dem sie mit einer Geschwingkeit von 5-100 cm/s durch eine Aktivkohlesäule geleitet wurden, und der Elektrolyt kontinuierlich dem Elektrolysieren innerhalb von 20 Minuten nach der Behandlung mit Aktivkohle unterworfen wird.

2. Verfahren nach Anspruch 1, wobei die Kupferionen von Kupfer(II)sulfat oder Kupfer(II)chlorid stammt.

## Revendications

1. Procédé continu pour la production d'une feuille de cuivre par électrodéposition, comprenant l'étape consistant :
à électrolyser un électrolyte contenant des ions cuivre, qui consiste en 50 à 100 g/l d'ions cuivre et un membre choisi dans le groupe consistant en 80 à 180 g/l d'acide sulfurique, 5 à 50 g/l d'acide chlorhydrique et un borofluorure en une quantité correspondant à une valeur de pH de 0,1 à 2,0, l'électrolyse étant effectuée à une température de l'électrolyte de 40 à 60°C et une densité de courant de 30 à 120 A/dm², au moins 60 % en volume dudit électrolyte étant traités de manière continue avec du charbon actif par passage à travers une colonne de charbon actif à une vitesse de 5 à 100 cm/s, ledit électrolyte étant soumis d'une manière continue à ladite étape d'électrolyse dans les 20 minutes suivant ledit traitement avec du charbon actif.

2. Procédé suivant la revendication 1, dans lequel l'ion cuivre est dérivé du sulfate cuivrique ou du chlorure cuivrique.
